# EUROPEAN PATENT SPECIFICATION

(11) **EP 2 208 608 B1**
(45) Date of publication and mention of the grant of the patent: **26.08.2020**
(21) Application number: 08843423.8
(22) Date of filing: 30.10.2008
(51) Int. Cl.: B29C 59/04, B29C 59/02, G03F 7/20, B82Y 10/00, B82Y 40/00, G03F 7/00, G11B 7/26

(54) **TRANSFER METHOD AND TRANSFER DEVICE**
ÜBERTRAGUNGSVERFAHREN UND ÜBERTRAGUNGSVORRICHTUNG
MÉTHODE ET DISPOSITIF DE TRANSFERT

(30) Priority: 30.10.2007 JP 2007281043
(43) Date of publication of application: 21.07.2010
(73) Proprietor: Toshiba Kikai Kabushiki Kaisha, Chiyoda-ku Tokyo 1000011 (JP)
(72) Inventor: SERIZAWA, Mitsuaki, Numazu-shi, Shizuoka-ken (JP); YAGI, Masayuki, Numazu-shi, Shizuoka-ken (JP)
(74) Representative: Hoffmann Eitle
(86) International application number: PCT/JP2008/069769
(87) International publication number: WO 2009/057700

(56) References cited:
- EP-A1- 0 540 455
- JP-A- 2003 181 918
- JP-A- 2005 035 119
- JP-A- 2007 260 485
- JP-A- 2008 194 976
- JP-T- 2006 503 694
- US-A1- 2006 263 530

## Description

### TECHNICAL FIELD

The present invention relates to a transfer method and a transfer apparatus using moulds to give a form of fine concavo-convex shapes on the surface of resin, and more particularly to a method and an apparatus to coat a base film with resin and press moulds on the resin to transfer concavo-convex patterns.

### BACKGROUND ART

As a method for forming concavo-convex patterns for optical recording media and the like, there has been known a transfer method in which moulds are pressed on resin such as an ultraviolet curable resin to give a form of the patterns. In this transfer method, as disclosed in Japanese Patent Application Laid-Open Publication No. H11-345436 (patent document 1), an ultraviolet curable resin is applied in a dispenser method or a roll transfer method on a length of resin sheet fed forth from a feeding member; and a stamper, which is moulds, is pressed on the applied ultraviolet curable resin to give a form, and on the ultraviolet curable resin given the form are irradiated ultraviolet rays to cure the resin.

As a method for applying resin on a resin sheet, besides the above-noted dispenser method and roll transfer method, there is one called a coating method in which resin is delivered from a coating die in a film form to be applied on a resin sheet. All the conventional coating methods are a method in which resin is applied in succession on a resin sheet.

However, the moulds for giving a form is not provided in succession all along a running direction of a resin sheet, but for example fixed on only a part of the periphery of a roll, as is same in patent document 1. It is thus common for a resin sheet to have s portion that is not pressed by the moulds.
In the portion not pressed by the moulds, the resin is to be cured without a transfer of patterns, resulting in a waste of resin. Further, since the resin is not to be moulded into grooves of the moulds, an excessive amount of application may lead to an overflow of the resin, causing troubles in operation,
Meanwhile, in the above-noted coating method, there is an intermittent coating method disclosed in Japanese Patent Application Laid-Open Publication No. 2002-45762. The intermittent coating method is a method in which a coating agent is applied intermittently on a sheeted substrate. By adopting the intermittent coating method into a transfer method that is the subject of the present invention, it is possible to have a highly advantageous transfer.

US 2006/0263530 A1 discloses a method according to the preamble of claim 1 and an apparatus according to the preamble of claim 2, it relates to a system and process for making non-continuous articles with patterned microstructures. The articles are reported to be of high quality and are reported to be usable in flat panel display applications. The system and process use a casting roll with a pattern on the surface of the casting roll for patterning a non-continuous microstructure on a surface of the substrate, and a coating device that is adapted to apply a coating to the surface of the substrate in a non-continuous manner so that areas of the substrate that are coated by the coating device correspond to the casting roll pattern.

### DISCLOSURE OF THE INVENTION

It is an object of the present invention by adopting the above-noted intermittent coating method into the field of transfer to provide a transfer method and a transfer apparatus to prevent a waste 'of resin and to eliminate a supply of resin to a portion of a base film not pressed by moulds to enable an advantageous transfer.

To achieve the above-noted objects a transfer method according to an aspect of the present invention is a transfer method having the features of claim 1.

A transfer apparatus according to an aspect of the present invention is a transfer apparatus according to claim 2.

### BRIEF DESCRIPTION OF THE DRAWINGS

[Fig. 1] Fig. 1 is a schematic configuration view illustrating an embodiment of a transfer apparatus.
[Fig. 2] Fig. 2 is an enlarged, view illustrating moulds and a mould roll in Fig. 1. Fig. 2(a) is a plane view, and Fig. 2(b) is a side view.
[Fig. 3] Fig. 3 is a schematic configuration view illustrating an example of an intermittent coating member in Fig. 1.
[Fig. 4] Fig. 4 is a schematic configuration view illustrating another embodiment of a transfer apparatus according to the present invention.

### BEST MODE FOR CARRYING OUT THE INVENTION

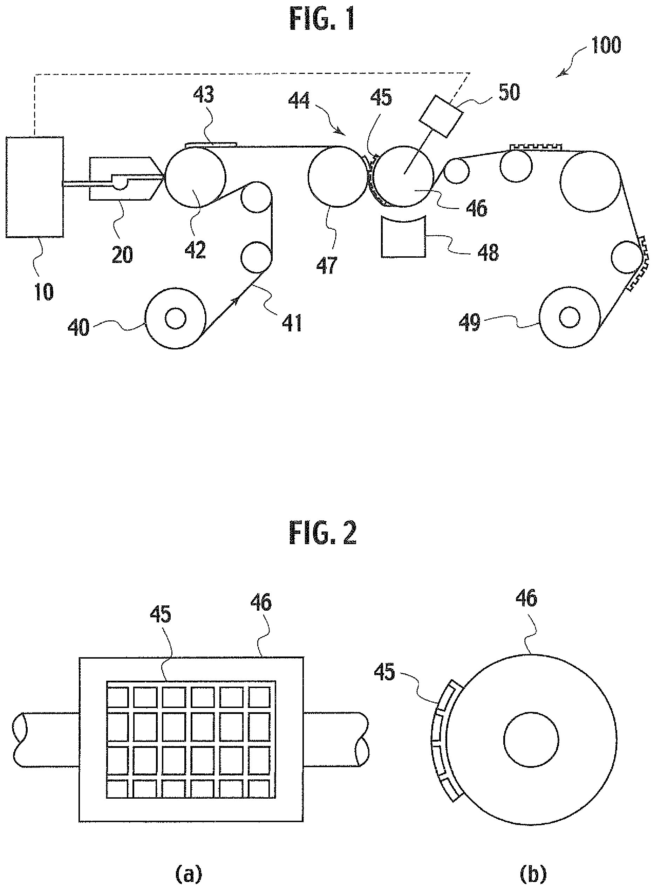

Description is made of a transfer apparatus with reference to Fig. 1 to Fig. 3. Fig. 1 is a schematic configuration view of the transfer apparatus. A transfer apparatus 100 is configured with an intermittent coating member 10 including a coating die 20 (described in detail later on).

The coating die 20 is arranged opposite to the periphery of a backup roll 42 that winds on and runs a length of base film 41 fed forth from a feeding member 40. The coating die 20 is adapted for a coating on the base film that is an intermittent application as will be described later on, of coats of a coating film 43 made of an ultraviolet curable resin, for instance.

A transfer member 44 includes: a mould roll 46 with moulds (moulds of a roll type) 45 fixed on the periphery thereof; a press roll 47 closely aligned to the mould roll 46 in pairs; and an ultraviolet irradiation device 48 opposed to the mould roll 46. Since these are configured similar to a typical transfer apparatus, description in detail will be omitted, while the moulds 45 are fixed on only a part of the periphery of the mould roll 46 as illustrated in Fig. 2.

After a transfer on the coating film 43 at the transfer member 44 with the moulds 45, the base film 41 is wound up by a winding member 49.

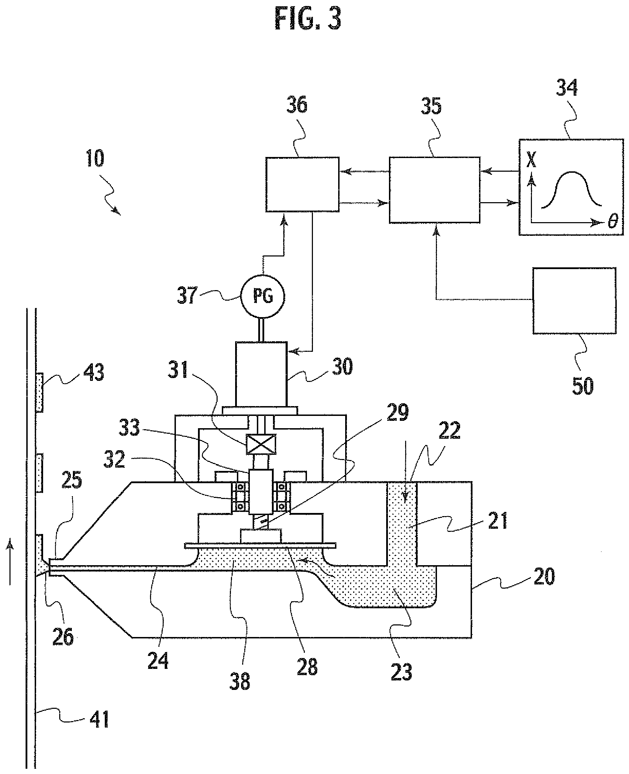

Fig. 3 illustrates an example of the intermittent coating member 10, which is one described in the above-noted patent document 2. At the intermittent coating member 10, the coating die (applying die) 20 has a coating agent 21 introduced thereto from an inlet 22. The coating agent 21 is kept once in a manifold 23 and then delivered through a supply path 24 to an outlet 26 provided at a lip 25, in a film form to be applied on the surface of a substrate traveling in the upper direction (direction shown in an arrow), that is the base film 41 illustrated in Fig. 1.

On the supply path 24, there is provided a diaphragm 28 that configures a part of the path. The diaphragm 28 has a screw axis 29 coupled thereto. The screw axis 29 is screwed into a ball nut 33 that is mounted for rotation-only by a bearing 32. The ball nut 33 has a servomotor 30 coupled thereto through a coupling 31.

The servomotor 30 has rotation amount and rotation speed thereof to be regulated automatically by a controller 35, a servo driver 36 and a pulse generator 37. The servomotor 30 is configured to displace the diaphragm 28 for a displacement amount 'X' of the diaphragm 28 against a rotation angle *θ* of the ball nut 33 to satisfy a relationship in a displacement setting curve 34.

When the diaphragm 28 is displaced upward to thereby increase the volume of a coating agent lead-in space 38, the coating agent 21 introduced from the inlet 22 is led and stored in the space 38. Accordingly, when the diaphragm 28 is displaced upward, it stops the delivery of the coating agent 21 at the outlet 26.

On the other hand, when the diaphragm 28 is displaced downward to thereby decrease the volume of the coating agent lead-in space 38, the coating agent 21 stored in the coating agent lead-in space 38 is delivered through the supply path 24 and brought together with the coating agent 21 introduced from the inlet 22 to be delivered at the outlet 26. This enables the intermittent application of the coating film 43 on the base film 41 as illustrated in Fig. 3.

The controller 35 for the intermittent coating member 10 has a travel distance measurement device 50 connected thereto. The travel distance measurement device 50 is mounted to the mould roll 46 to measure a travel distance of the base film 41 as illustrated in Fig. 1. The travel distance measurement device 50 constitutes a synchronism control member that synchronizes the intermittent coating member 10 and the transfer member 44. The synchronism control member is configured to actuate the intermittent coating member 10 in synchronism with rotation of the mould roll 46, that is in synchronism with a travel distance of the base film 41, to align each coat of the coating film 43 on the base film 41 with the moulds 45 on the mould roll 46.

Description is now made of actions of the apparatus. There is a length of base film 41 fed forth from the feeding member 40 on which the intermittent coating member 10 provides an intermittent application of coats of a coating film 43 made of an ultraviolet curable resin that is the coating agent 21 delivered intermittently from the coating die 20.

Each coat of the coating film 43 on the base film 41 is delivered to the transfer member 44 by the travel of the base film 41 to be given a transfer by the moulds 45 on the mould roll 46 and the pressure roll 47. On this occasion, since each coat of the coating film 43 has been formed on an area limited to a portion facing to the moulds 45, it prevents the waste of ultra curable resin to form the coating film 43 and also eliminates the supply of resin to a portion not facing to the moulds 45 and the concavo-convex patterns thereof. It is thus possible to have an advantageous transfer without troubles by an overflow of the resin to affect operation, or the like.

Each coat of the coating film 43, which is given a transfer, is cured with the ultraviolet irradiation device 48 to finish the transfer step and is wound up along with the base film 41 by the winding member 49.

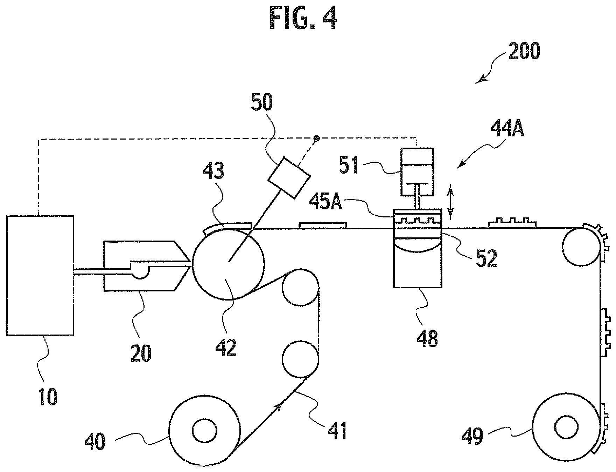

Fig. 4 is a schematic configuration view of an embodiment according to the present invention. The example in Fig. 1 describes an example to use the moulds of a roll type 45 fixed on the mould roll 46 adapted for continuous rotation and to run the base film 41 continuously. Instead, this embodiment describes to use a transfer member 44A with moulds of a press type 45A that are opposed each other to open and close and to run the base film 41 intermittently, where a length of base film 41 is intermittently fed forth from the feeding member 40 and intermittently wound up by the winding member 49.

The transfer member 44A is provided with: a pressure device 51 to open and close to press the moulds 45A; and a supporting plate 52 that is transparent. The travel distance measurement device 50 is mounted to the backup roll 42 and configured to actuate the intermittent coating member 10 and the transfer member 44A in synchronism with a travel distance of the base film 41.

The apparatus provides an intermittent application of coats of a coating film 43 with the intermittent coating member 10 on the base film 41 traveling intermittently, stops each coat of the coating film 43 at a position corresponding to the transfer member 44A, and implements a transfer by the moulds of a press type 45A during the stop. With the apparatus, it is possible to achieve the same effect with that of the apparatus in Fig. 1.

The aforementioned embodiment describes an example of providing the coating agent lead-in space 38 to the coating die 20, which is used for an intermittent delivery of the coating agent 21 at the outlet 26 of the intermittent coating member 10. The invention, however, is not limited to the present configuration. It is possible to provide the coating agent lead-in space 38 upstream of the coating agent supply path near the inlet 22. Also, as means of increasing and decreasing the volume of the coating agent lead-in space 38, it is possible not to limit to the diaphragm 28 but to employ various intermittent coating devices such as cylinder and piston, or the like. Further, needless to say, as a resin to form the coating film 43, it is possible not to limit to an ultraviolet curable resin, but to employ another resin like a heat curable resin, or the like.

As apparent from the previous description, the present invention provides to intermittent-deliver resin from the coating die onto the base film, to intermittent-coat the base film with the resin, and to press the moulds on the intermittent coats of resin in synchronism with the intermittent coating for transfer of the concavo-convex patterns. This achieves the effect of preventing a waste of resin and eliminating a supply of resin on the portion not facing to the moulds to enable an advantageous transfer.

### Industrial Application

The present invention will be applied to a transfer method and a transfer apparatus to coat a base film with resin and press moulds intermittently on the resin to transfer concavo-convex patterns.

## Claims

1. A transfer method including coating a base film with resin, and pressing moulds on a coat of resin, to transfer concavo-convex patterns, the method comprising the steps of:
intermittent-delivering resin from a coating die (20) onto the base film (41);
intermittent-coating the base film (41) with delivered resin;
measuring a travel distance of the base film (41), and
pressing the moulds (45) on intermittent coats of resin in synchronization with the intermittent-coating, for transfer of the patterns,
wherein the synchronization of the intermittent-coating and the transfer is on the basis of feedback on the measured travel distance of the base film (41),
**characterized in that**
the base film (41) travels intermittently, and the transfer is implemented by moulds (45A) of a press type opposed each other to open and close.

2. A transfer apparatus to coat a base film (41) with resin and press moulds on a coat of resin to transfer concavo-convex patterns, comprising:
an intermittent coating member (10) that is arranged to intermittent-deliver resin from a coating die (20) onto the base film (41) and is arranged to intermittent-coat the base film (41) with delivered resin;
a transfer member (44) that is arranged to press the moulds (45) on intermittent coats of resin in synchronization with the intermittent-coating, for transfer of the patterns; and
a synchronization control member that is arranged to actuate the intermittent coating member and the transfer member in synchronization,
wherein the synchronization control member has a travel distance measurement device (50) for measuring the travel distance of the base film (41) and is arranged to synchronize the intermittent coating member (10) and the transfer member (44) on the basis of feedback on the measured travel distance of the base film (41),
**characterized in that**
the moulds are moulds (45A) of a press type opposed each other to open and close.

## Patentansprüche

1. Übertragungsverfahren, das das Beschichten einer Basisfolie mit Harz und Pressformen auf einer Harzschicht beinhaltet, um konkav-konvexe Muster zu übertragen, wobei das Verfahren folgende Schritte umfasst:
intermittierendes Zuführen von Harz von einer Beschichtungsdüse (20) auf die Basisfolie (41),
intermittierendes Beschichten der Basisfolie (41) mit zugeführtem Harz,
Messen des Wegabstands der Basisfolie (41) und Pressen der Formen (45) auf intermittierende Schichten des Harzes synchron mit der intermittierenden Beschichtung für die Übertragung der Muster,
wobei der Synchronismus der intermittierenden Beschichtung und der Übertragung auf der Basis der Rückmeldung zum gemessenen Wegabstand der Basisfolie (41) erfolgt,
**dadurch gekennzeichnet, dass**:
die Basisfolie (41) intermittierend fährt und die Übergabe durch Formen (45A) eines Pressentyps umgesetzt wird, die einander gegenüberliegen, um sich zu öffnen und zu schließen.

2. Übertragungseinrichtung zum Beschichten einer Basisfolie (41) mit Harz und Pressformen auf einer Harzschicht zur Übertragung von konkav-konvexen Mustern, umfassend:
ein intermittierendes Beschichtungselement (10), das angeordnet ist, um Harz intermittierend aus einer Beschichtungsdüse (20) auf die Basisfolie (41) zu liefern und angeordnet ist, um die Basisfolie (41) intermittierend mit zugeführtem Harz zu beschichten,
ein Übertragungselement (44), das angeordnet ist, um die Formen (45) auf intermittierende Schichten des Harzes synchron mit der intermittierenden Beschichtung zu drücken, um die Muster zu übertragen, und
ein Synchronismus-Steuerelement, das angeordnet ist, um das intermittierende Beschichtungselement und das Übertragungselement synchron zu betätigen,
wobei das Synchronismus-Steuerelement eine Wegabstandsmessvorrichtung (50) für die Messung des Wegabstands der Basisfolie (41) aufweist und angeordnet ist, um das intermittierende Beschichtungselement (10) und das Übertragungselement (44) in Abhängigkeit von der Rückmeldung zum Wegabstand der Basisfolie (41) zu synchronisieren,
**dadurch gekennzeichnet, dass**
es sich bei den Formen um Formen (45A) eines Pressentyps handelt, die einander gegenüberliegen, um sich zu öffnen und zu schließen.

## Revendications

1. Procédé de transfert incluant une application en revêtement de résine sur un film de base, et un pressage de moules sur une couche de résine, pour transférer des motifs concavo-convexes, le procédé comprenant les étapes consistant à :
délivrer par intermittence une résine à partir d'une filière d'application en revêtement (20) sur le film de base (41) ;
appliquer en revêtement par intermittence de la résine délivrée sur le film de base (41) ;
mesurer une distance de déplacement du film de base (41), et
presser les moules (45) sur des couches de résine intermittentes en synchronisation avec l'application en revêtement par intermittence, pour un transfert des motifs,
dans lequel la synchronisation de l'application en revêtement par intermittence et du transfert est basée sur une rétroaction sur la distance de déplacement mesurée du film de base (41),
**caractérisé en ce que**
le film de base (41) se déplace par intermittence, et le transfert est mis en œuvre par des moules (45A) du type presse opposés l'un à l'autre pour s'ouvrir et se fermer.

2. Appareil de transfert pour une application en revêtement de résine sur un film de base (41), et un pressage de moules sur une couche de résine, pour transférer des motifs concavo-convexes, comprenant
un élément d'application en revêtement par intermittence (10) qui est agencé pour délivrer de la résine par intermittence à partir d'une filière d'application en revêtement (20) sur le film de base (41) et est agencé pour appliquer en revêtement par intermittence de la résine délivrée sur le film de base (41) ;
un élément de transfert (44) qui est agencé pour presser les moules (45) sur des couches de résine intermittentes en synchronisation avec l'application en revêtement par intermittence, pour un transfert des motifs ; et
un élément de commande de synchronisation qui est agencé pour actionner l'élément d'application en revêtement par intermittence et l'élément de transfert en synchronisation,
dans lequel l'élément de commande de synchronisation a un dispositif de mesure de distance de déplacement (50) pour mesurer la distance de déplacement du film de base (41) et est agencé pour synchroniser l'élément d'application en revêtement par intermittence (10) et l'élément de transfert (44) sur la base d'une rétroaction sur la distance de déplacement mesurée du film de base (41),
**caractérisé en ce que**
les moules sont des moules (45A) du type presse opposés l'un à l'autre pour s'ouvrir et se fermer.
